# EUROPÄISCHE PATENTSCHRIFT

(11) **EP 1 390 988 B1**
(45) Veröffentlichungstag und Bekanntmachung des Hinweises auf die Patenterteilung: **26.07.2006**
(21) Anmeldenummer: 02727197.2
(22) Anmeldetag: 05.03.2002
(51) Int. Cl.: H01L 31/18, H01L 31/028, B28B 1/00

(54) **Verfahren zum Erzeugen von optisch transparenten Bereichen in einem Siliziumsubstrat**
Method for producing optically transparent regions in a silicon substrate
Procédé pour produire des zones optiquement transparentes dans un substrat de silicium

(30) Priorität: 14.04.2001 DE 10118568
(43) Veröffentlichungstag der Anmeldung: 25.02.2004
(73) Patentinhaber: ROBERT BOSCH GMBH, 70442 Stuttgart (DE)
(72) Erfinder: BENZEL, Hubert, 72124 Pliezhausen (DE); WEBER, Heribert, 72622 Nuertingen (DE); ARTMANN, Hans, 71106 Magstadt (DE); SCHAEFER, Frank, 72070 Tuebingen (DE)
(86) Internationale Anmeldenummer: PCT/DE2002/000798
(87) Internationale Veröffentlichungsnummer: WO 2002/084748

(56) Entgegenhaltungen:
- DE-A- 19 803 852
- FR-A- 2 670 579
- US-A- 4 680 963
- US-A- 5 231 878
- US-A- 5 387 803
- US-A- 5 461 001
- LAMMEL G ET AL: "Free-standing, mobile 3D porous silicon microstructures" SENSORS AND ACTUATORS A, ELSEVIER SEQUOIA S.A., LAUSANNE, CH, Bd. 85, Nr. 1-3, 25. August 2000 (2000-08-25), Seiten 356-360, XP004214496 ISSN: 0924-4247

## Beschreibung

### Stand der Technik

Die Erfindung betrifft ein Verfahren zum Erzeugen von optisch transparenten Bereichen in einem Siliziumsubstrat sowie eine in einem Siliziumsubstrat ausgebildete Struktur, die mit einem solchen Verfahren erzeugt werden kann.

Es ist bekannt, dass Siliziumoxid annähernd die gleichen optischen Eigenschaften wie Quarzglas aufweist, d. h. im sichtbaren Spektralbereich durchsichtig ist. Zum Herstellen optisch transparenter Bereiche in Verbindung mit einem Siliziumsubstrat werden in der Praxis Siliziumoxidschichten auf dem Siliziumsubstrat abgeschieden, die dann anschließend strukturiert werden.

Das bekannte Verfahren ist jedoch in mehrerlei Hinsicht problematisch. So können mit dem bekannten Verfahren nur optisch transparente Bereiche mit relativ geringer Schichtdicke erzeugt werden. Außerdem ist die Herstellung eines solchen optisch transparenten Bereichs über einem Hohlraum im Siliziumsubstrat nicht ohne weiteres möglich, sodass die im Rahmen des bekannten Verfahrens erzeugten optisch transparenten Bereiche in der Regel nicht als optisch transparente Abdeckung eines Hohlraums oder Fluidkanals genutzt werden können, wie sie beispielsweise für optische Untersuchungen an kleinsten Flüssigkeitsmengen in der Medizin oder Analytik benötigt werden.

Aus der Schrift DE 198 03 852 A1 ist ein elektrochemisches Ätzverfahren zur Herstellung dicker Siliziumoxidschichten auf einem kristallinen Wafer bekannt. Der Siliziumwafer wird dabei wechselseitig in einem Ätzbecken unter anodischem Ätzen mit einer porösen Siliziumschicht versehen. Nach der Herstellung der porösen Siliziumschicht auf der Vorder-und Rückseite des Siliziumwafers erfolgt in einem weiteren Schritt ein Oxidationsschritt, der dazu dient, das Skelett des porösen Siliziums zu oxidieren und schließlich vollständig in ein Oxidskelett umzuwandeln. In einem weiteren Schritt erfolgt nach der Oxidation ein Temperschritt, um das entstandene poröse Oxid zu verdichten.

Aus der Schrift US 5,387,803 ist ein (druck-)spannungsabhängiger Halbleiter bekannt, der einen porösen Bereich eines Halbleitermaterials mit einer (druck-)spannungsabhängigen Lichtabsorption aufweist. Um einen "stress concentrator" herzustellen, der auf den (druck-)spannungsabhängige porösen Bereich wirkt, wird eine photolithographische Maske auf einen Siliziumwafer aufgebracht, um den Wafer in einem ersten Ätzschritt mittels einer KOH-Ätzung stellenweise zu dünnen. Anschließend wird der Wafer in einem zweiten Ätzschritt stellenweise im Bereich 426 mittels einer elektrochemischen Anodisierung porös geätzt.

Aus der Schrift Lammel et al., Sensors and Actuators 85 (2000), 356-360 ist ein Verfahren zur Erzeugung einer porösen Schicht in einem dotierten Siliziumsubstrat bekannt, die durch ein elektrochemisches Ätzverfahren gebildet wird. Durch eine Erhöhung der Stromdichte wird der elektrochemische Ätzprozess zu einem elektropolierenden Ätzprozess, in dem das Silizium unterhalb des porösen Bereichs entfernt wird. Anschließend werden die Poren des porösen Bereichs durch eine Oxidation geschlossen. Unter der so entstandenen Membran aus oxidiertem porösen Silizium wird eine Kavität erzeugt, die ein Vakuum einschließt.

### Vorteile der Erfindung

Mit der vorliegenden Erfindung wird eine einfache und kostengünstige Möglichkeit zur Erzeugung optisch transparenter Bereiche in einem Siliziumsubstrat vorgeschlagen, mit dem sich sowohl optisch transparente Bereiche belkbiger Dicke als auch optisch transparente Bereiche über einem Hohlraum im Siliziumsubstrat realisieren lassen.
Dazu wird erfindungsgemäß mindestens ein definierter Bereich des Siliziumsubstrats porös geätzt. Danach wird der definierte poröse Bereich des ''Siliziumsubstrats oxidiert.

Ausgehend von der Tatsache, dass sich Siliziumoxid gut für die "Realisierung optisch transparenter Bereiche in einem Siliziumsubstrat eignet, ist erfindungsgemäß erkannt worden, dass das Siliziumoxid nicht auf der Substratoberfläche abgeschieden werden muss, sondern auch im Siliziumsubstrat selbst erzeugt werden kann, wenn eine hinreichend große Angriffsfläche für die Oxidation des Siliziums geschaffen wird. Erfindungsgemäß wird daher vorgeschlagen, das Siliziumsubstrat dort porös zu ätzen, wo ein transparenter Bereich entstehen soll. Im Rahmen eines nachfolgenden Oxidationsprozesses wird das Silizium in dem porösen Bereich dann in das optisch transparente Siliziumoxid umgewandelt.

Da das Siliziumsubstrat problemlos bis in beliebige Tiefen porös geätzt werden kann, können auf diese Weise einfach optisch transparente Bereiche erzeugt werden, die sich beliebig tief ins Siliziumsubstrat und auch über die gesamte Dicke des Siliziumsubstrats erstrecken. Außerdem lassen sich poröse Bereiche im Siliziumsubstrat auch einfach unterätzen, so dass das erfindungsgemäße Verfahren auch die Möglichkeit eröffnet, optisch transparentebereiche über einem Hohlraum im Siliziumsubstrat zu realisieren.

Grundsätzlich gibt es verschiedene Möglichkeiten für die Realisierung des erfindungsgemäßen Verfahrens und insbesondere für die Wahl eines geeigneten Ätzprozesses.

Eine Möglichkeit besteht darin, den definierten Bereich des Siliziumsubstrats in einem elektrochemischen Ätzprozess porös zu ätzen. In diesem Zusammenhang erweist sich das elektrochemische Anodisieren als besonders vorteilhaft. Der Materialabtrag erfolgt hier bei Stromfluss an der anodischen Seite des Siliziumsubstrats, d.h. an der mit der Anode kontaktierten Seite des Siliziumsubstrats.

Besonders gute Ergebnisse lassen sich insbesondere beim Anodisieren erzielen, wenn ein flusssäurehaltiges Medium als Ätzlösung verwendet wird. Dabei kann es sich beispielsweise um eine Flusssäure-Ethanol-Lösung oder auch eine wässrige Flusssäurelösung handeln, die zusätzlich mit Netzmitteln versehen werden kann

Während sich die Tiefe des definierten porösen Bereichs im Rahmen des erfindungsgemäßen Verfahrens einfach durch die Dauer des Ätzprozesses vorgeben lässt, ist die in dem Ätzprozess erzeugte Porosität von verschiedenen Parametern, wie der Dotierung des Siliziumsubstrats, der Konzentration der Ätzlösung und der während des Ätzprozesses am Siliziumsubstrat anliegenden Stromstärke abhängig. Die Porosität kann also über einen oder mehrere dieser Parameter gezielt beeinflusst werden.

Im Rahmen des Oxidationsprozesses erfährt das poröse. Siliziumsubstrat einen Volumenzuwachs, der zu Verspannungen im Siliziumsubstrat und in Folge zu Defekten in der Struktur und/oder Funktion des aus dem Siliziumsubstrat gefertigten Bauteils führen kann. Andererseits wirken sich eine nach der Oxidation verbleibende Restporosität oder eine unvollständige Oxidation des porösen Bereichs negativ auf die mechanischen und optischen Eigenschaften des transparenten Bereichs aus. Deshalb sollten der Ätzprozess und die Oxidationsbedingungen, insbesondere die Dauer der Oxidation, aufeinander abgestimmt werden. Besonders vorteilhaft in diesem Zusammenhang ist es, wenn die in dem definierten Bereich erzeugte Porosität so groß ist, dass die Poren durch den Volumenzuwachs beim vollständigen Durchoxidieren vollständig geschlossen werden, ohne dass Verspannungen im Siliziumsubstrat auftreten. Eine Porosität des Siliziumsubstrats von ca. 54% hat sich hierfür als geeignet erwiesen.

Zum Erzeugen von lokal begrenzten porösen Bereichen als Vorstufe von lokal begrenzten optisch transparenten Bereichen im Siliziumsubstrat hat sich die Verwendung von Ätzmasken bewährt, die auf mindestens eine Oberfläche des Siliziumsubstrats aufgebracht werden und so die zu ätzenden Bereiche zumindest in dieser Ebene definieren. Insbesondere wenn die Porosität in einem elektrochemischen Ätzprozess erzeugt werden soll, erweist sich die Verwendung einer Metallmaske als Ätzmaske als besonders vorteilhaft. In diesem Fall verläuft der Stromfluss nämlich senkrecht zur Substratoberfläche, so dass keine Unterätzung der Metallmaske auftritt. Optional kann zusätzlich auch auf der anderen Seite des Siliziumsubstrats eine Metallmaske aufgebracht werden, um die Stromlinien noch besser zu führen. Als Ätzmaske kommt aber auch eine Siliziumnitridmaske in Frage oder eine n⁺-Dotierung ggf. in Verbindung mit einer zusätzlichen Siliziumnitridmaske.

Wie bereits erwähnt, können die mit dem erfindungsgemäßen Verfahren erzeugten optisch transparenten Bereiche in vorteilhafter Weise als Abdeckungen für Hohlräume und Kanäle im Siliziumsubstrat genutzt werden. In einer vorteilhaften Weiterbildung des erfindungsgemäßen Verfahrens werden derartige Hohlräume unterhalb des definierten porösen Bereichs erzeugt, indem der Ätzprozess als Hohlraum-Ätzprozess unter Bedingungen fortgesetzt wird, bei denen das Siliziumsubstrat vollständig herausgeätzt wird, insbesondere indem der Ätzprozess mit einer geringer konzentrierten Ätzlösung und/oder mit einer höheren am Siliziumsubstrat anliegenden Stromstärke fortgesetzt wird. Das bereits porös geätzte Siliziumsubstrat wird im Verlauf des Hohtraum-Ätzprozesses nicht weiter abgebaut, da die Ätzlösung nicht an den Seitenwandungen der Poren angreift sondern im wesentlichen nur am Porengrund. Die Ätzlösung gelangt also über die Poren jeweils zum Porengrund, von wo die Unterätzung des porösen Bereichs ausgeht. Die Größe des Hohlraums kann dann einfach über die Dauer des Hohlraum-Ätzprozesses bestimmt werden. Durch anschließende Oxidation wird das Silizium des porösen Bereichs in optisch transparentes Siliziumoxid umgewandelt.

In einer weiteren Fortbildung des erfindungsgemäßen Verfahrens ist es schließlich auch möglich, einen von zwei gegenüberliegenden optisch transparenten Bereichen begrenzten Hohlraum im Siliziumsubstrat zu erzeugen. Dazu wird der Ätzprozess nach Erzeugung des Hohlraums einfach wieder unter Bedingungen fortgesetzt, bei denen das Siliziumsubstrat porös geätzt wird, und zwar in der Regel so lange, bis das Siliziumsubstrat vollständig durchgeätzt ist.

### Zeichnungen

Wie bereits vorstehend ausführlich erörtert, gibt es verschiedene Möglichkeiten, die Lehre der vorliegenden Erfindung in vorteilhafter Weise auszugestalten und weiterzubilden. Dazu wird einerseits auf die dem Patentanspruch 1 nachgeordneten Patentansprüche sowie auf die Patentansprüche 6 und 7 verwiesen und andererseits auf die nachfolgende Beschreibung von Ausführungsbeispielen der Erfindung anhand der Zeichnungen.

Die Figuren 1a und 1b zeigen ein Siliziumsubstrat in zwei verschiedenen Stadien des erfindungsgemäßen Verfahrens und

Die Figuren 2 bis 4 sowie 5a und 5b zeigen verschiedene in einem Siliziumsubstrat ausgebildete Strukturen, die mit dem erfindungsgemäßen Verfahren hergestellt worden sind.

### Beschreibung der Ausführungsbeispiele

In Figur 1a ist ein Siliziumsubstrat 1 dargestellt, dessen eine Hauptoberfläche 2 mit einer Ätzmaske 3 versehen ist, wie sie üblicher Weise beim Ätzen eines Siliziumsubstrats verwendet wird. Das Mater der Ätzmaske 3 wird in Abhängigkeit von der Art des Ätzverfahrens gewählt. In Verbindung mit einem elektrochemischen Ätzprozess erweist sich die Verwendung einer Metallmaske als besonders vorteilhaft. Die Stromlinien verlaufen in diesem Fall senkrecht zur Substratoberfläche. Sodass keine Unterätzung der Ätzmaske auftreten kann. In Frage kommt aber auch die Verwendung einer n⁺ -Dotierung, einer Siliziumnitridmaske oder eine Kombination aus n⁺ -Dotierung und Siliziumnitridmaske.

Nach dem Aufbringen der Ätzmaske 3 auf der Substratoberfläche 2 wurde das Siliziumsubstrat 1 im hier dargestellten Ausführungsbeispiel einem elektrochemischen Ätzprozess in einem flusssäurehaltigen Medium ausgesetzt. Bei einem derartigen Ätzprozess wird das Siliziumsubstrat zwischen einer Anode und einer Kathode in einem Flusssäurebad positioniert, wobei die Kontaktierung des Siliziumsubstrats über das Flusssäurebad erfolgt. Da der Materialabtrag bei Stromfluss an der anodischen Seite des Siliziumsubstrats, hier der Substratoberfläche 2, erfolgt, wird ein derartiger Ätzprozess auch als Anodisierung bezeichnet. Aufgrund der Dotierung des hier dargestellten Siliziumsubstrats 1 sowie der Anodisierbedingungen, d.h. der Konzentration der Ätzlösung und der Stromstärke, wurden die ungeschützten Bereiche der Substratoberfläche 2 porös geätzt. Die dabei erzeugte Porosität des Siliziumsubstrats wurde in Abstimmung auf den anschließenden Oxidationsprozess so gewählt, dass der mit der Oxidation einhergehende Volumenzuwachs zwar die Poren in den porösen Bereichen 5 und 6 füllt aber nicht zu Verspannungen im Siliziumsubstrat 1 führt. Die Tiefe der porösen Bereiche 5 und 6 wurde durch die Dauer der Anodisierung bestimmt.

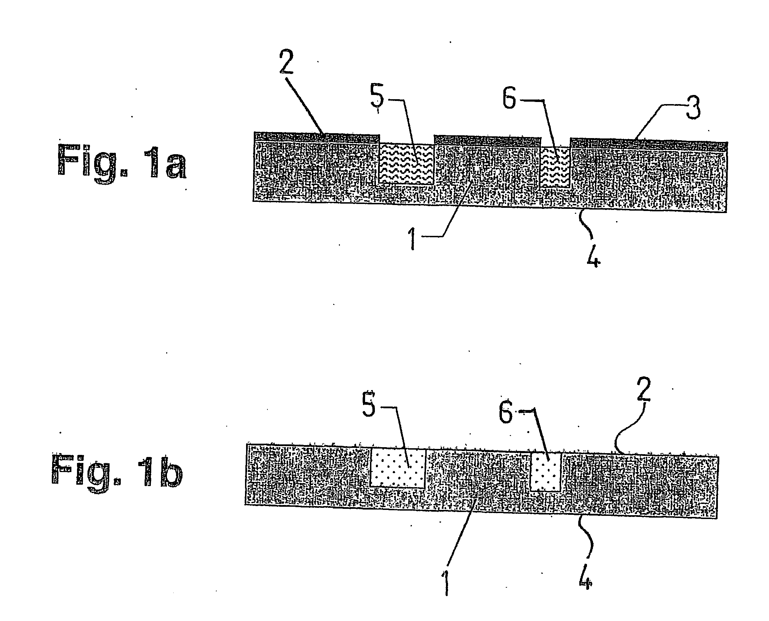

In Fig. 1b ist das Siliziumsubstrat 1 nach dem Entfernen der Ätzmaske 3 und nach der Oxidation dargestellt. Das poröse Silizium in den Bereichen 5 und 6 ist hier vollständig in Siliziumoxid umgewandelt worden, das im sichtbaren Spekrabereich optisch transparent ist. Poröses Silizium weist eine sehr große Oberfläche auf, so dass die Oxidation hier sehr rasch erfolgt. Demzufolge ist die Substratoberfläche 2 trotz der vollständigen Oxidation der porösen Bereiche 5 und 6 lediglich geringfügig oxidiert worden. Das Siliziumoxid auf der Substratoberfläche 2 kann daher einfach entfernt werden. Anschließend kann das Siliziumsubstrat 1 weiter bearbeitet werden, beispielsweise durch Einbringen weiterer Dotierungen, durch Metallisierungen, durch Abscheiden von Passivierungsschichten, etc..

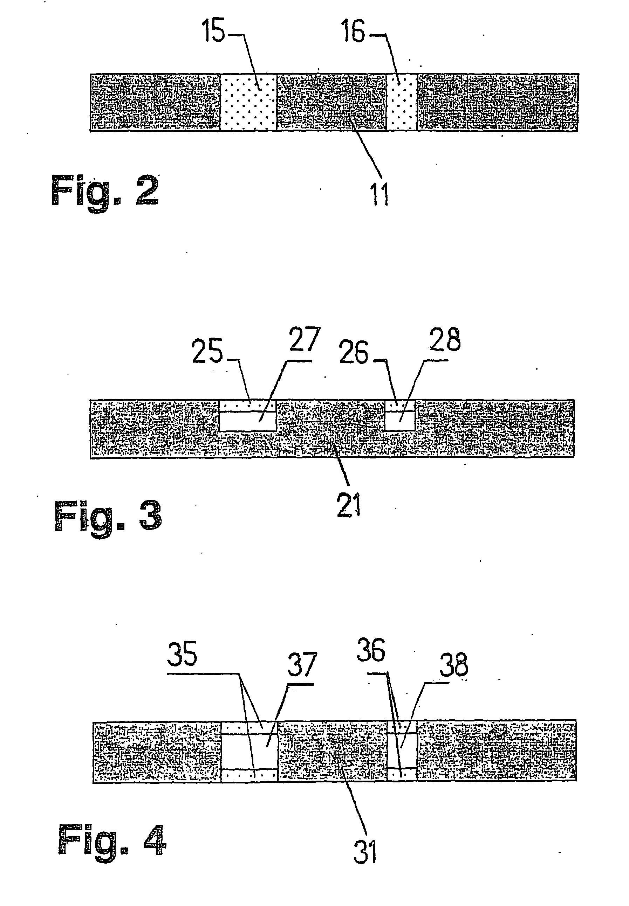

In Fig. 2 ist ein weiteres Siliziumsubstrat 11 dargestellt, in dem mit Hilfe des erfindungsgemäßen Verfahrens, wie es in Verbindung mit den "Figuren 1a und b erläutert worden ist, zwei optisch transparente Bereiche 15 und 16 erzeugt worden sind, die sich über die gesamte Dicke des Siliziumsubstrats 11 erstrecken. Dazu wurde die Anodisierung so lange durchgeführt, bis das Siliziumsubstrat 11 in den dem Ätzangriff ausgesetzten Bereichen 15 und 16 in seiner gesamten Dicke porös geätzt war. Die so erzeugten porösen Bereiche 15 und 16 wurden anschließend vollständig durchoxidiert.

In Fig. 3 ist ein Siliziumsubstrat 21 dargestellt, in dem zwei optisch transparente Bereiche 25 und 26 über jeweils einem Hohlraum 27 und 28 im Siliziumsubstrat 21 ausgebildet sind. Diese Struktur wurde ebenfalls mit Hilfe des erfiridungsgemäßen Verfahrens erzeugt, indem die Anodisierbedingungen nach dem porös Ätzen der Bereiche 25 und 26 so geändert wurden, dass das Silizium unterhalb der porösen Bereiche 25 und 26 vollständig herausgeätzt wurde. Dazu wurde die Konzentration der Flusssäurelösung erniedrigt und/oder die Stromstärke erhöht. Die Größe der Hohlräume 27 und 28 wurde durch die Dauer des Ätzangriffs mit geänderten Änodisierbedingungen bestimmt. Durch die anschließende Oxidation ist eine Struktur im Siliziumsubstrat 21 mit Hohlräumen 27 und 28 bzw. Kanälen und darüber liegenden optisch transparenten Bereichen 25 und 26 entstanden, mit der beispielsweise optische Messungen an vlüssigkeiten mit geringsten Volumina durchgeführt werden können.

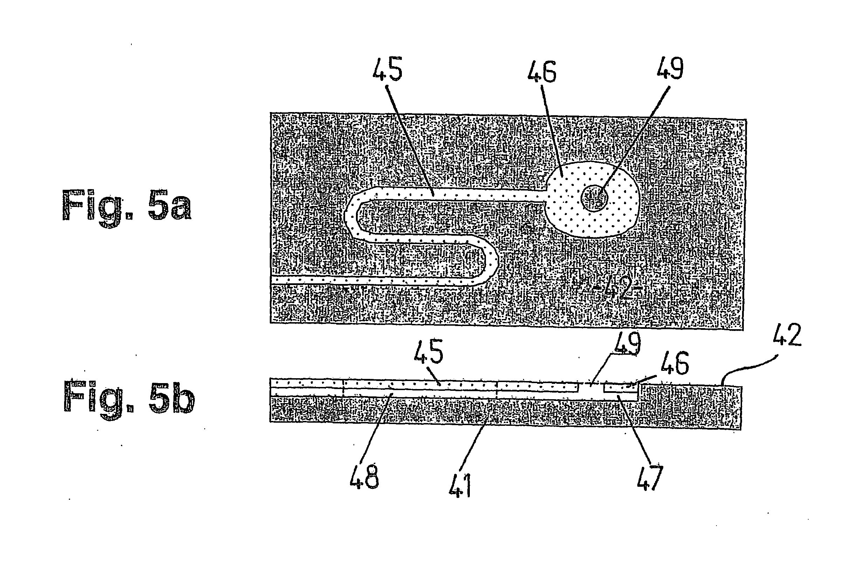

In Fig. 4 ist ein Siliziumsubstrat 31 dargestellt, in dem ebenfalls zwei optisch transparente Bereiche 35 und 36 über jeweils einem Hohlraum 37 und 38 ausgebildet sind. Dieser Teil der Struktur im Siliziumsubstrat 31 ist wie auch die in Fig. 3 dargestellte Struktur mit Hilfe des erfindungsgemäßen Verfahrens erzeugt worden. Im Falle der Fig. 4 wurde der Ätzprozess allerdings nach dem Ätzen der Hohlräume 37 und 38 unter den ursprünglichen Ätzbedingungen solange fortgesetzt, bis das gesamte unter den Hohlräumen 37 und 38 befindliche Silizium porös geätzt war. Das unter den Hohlräumen 37 und 38 befindliche Silizium kann alternativ dazu auch durch Umdrehen der ursprünglich beim Anodisieren angelegten-Spannung porös geätzt werden. Diese Variante erweist sich als besonders vorteilhaft, da das Siliziumsubstrat dann von der Unterseite her geätzt wird und das Ätzmedium und auch das herausgeätzte Silizium nicht durch die bereits erzeugten porösen Schichten auf der anderen Seite der Holräume dringen müssen. Dur chdie anschließende Oxidation ist hier eine Struktur im Siliziumsubstrat 31 entstanden, mit Hohlräumen 37 und 38 bzw. Kanälen, die zweiseitig von optisch transparenten Bereichen 25 und 26 begrenzt sind, so dass mit dieser Struktur beispielsweise optische Messungen in Durchsicht durchgeführt werden können.

Mit Hilfe des erfindungsgemäßen Verfahrens können auch Strukturen mit komplexeren Geometrien in einem Siliziumsubstrat erzeugt werden, wie z.B. die in den Figuren 5a und b in Draufsicht und in Schnittdarstellung wiedergegebene Struktur. Dabei handelt es sich um einen mäanderförmigen Kanal 48, der von einem ovalen Hohlraum 47 mit einer Zugangsöffnung 49 in der Substratoberfläche 42 ausgeht. Sowohl der Hohlraum 47 als auch der Kanal 48 sind im Siliziumsubstrat 41 unterhalb von ineinander übergehenden optisch transparenten Bereichen 45 und 46 ausgebildet.

In den voranstehend beschriebenen Ausführungsbeispielen wurden die optisch transparenten Bereiche in einem Siliziumsubstrat immer in einem gemeinsamen Ätzprozess mit anschließender Oxidation erzeugt. Selbstverständlich kann das erfindungsgemäße Verfahren auch mehrmals hintereinander auf ein jeweils unterschiedlich maskiertes Siliziumsubstrat angewendet werden, um optisch transparente Bereiche mit unterschiedlicher Tiefe und auch in unterschiedlicher Höhe im Siliziumsubstrat zu erzeugen. So könnte in einem ersten Schritt durch geeignete Maskierung der Substratoberfläche ein erster optisch transparenter Bereich mit einer bestimmten Tiefe erzeugt werden. Mit Hilfe einer zweiten Maskierung könnte dann ein weiterer optisch transparenter Bereich mit einer anderen Tiefe erzeugt werden oder auch ein transparenter Bereich, der von einer vorher erzeugten Vertiefung in der Substratoberfläche ausgeht. Auf diese Weise lassen sich mit Hilfe des erfindungsgemäßen Verfahrens komplexe Tiefenprofile mit transparenten Bereichen in einem Siliziumsubstrat realisieren.

## Patentansprüche

1. Verfahren zur Herstellung wenigstens
- eines porösen Bereichs und
- eines unter dem porösen Bereich befindlichen Hohlraums
in einem Siliziumsubstrat,
wobei die Herstellung die Verfahrensschritte
- Erzeugung des porösen Bereichs in dem Siliziumsubstrat mittels eines elektrochemischen Ätzprozesses und
- Erzeugung des Hohlraums innerhalb des porösen Bereichs durch eine Fortsetzung des Ätzprozesses, wobei eine Änderung der Bedingungen des Ätzprozesses erfolgt umfasst,
**dadurch gekennzeichnet, dass**
in dem Siliziumsubstrat ein im sichtbaren Spektralbereich optisch transparenter Bereich durch Oxidation des porösen Bereichs erzeugt wird.

2. Verfahren nach Anspruch 1, **dadurch gekennzeichnet, dass** zur Erzeugung des Hohlraums die Konzentration der Ätzlösung beim Ätzprozess verringert wird und/oder die Stromstärke des elektrochemischen Ätzprozesses erhöht wird.

3. Verfahren nach Anspruch 1, **dadurch gekennzeichnet, dass** der Hohlraum als Kanal ausgestaltet wird.

4. Verfahren zur Erzeugung von mehreren im sichtbaren Spektralbereich optisch transparenten Bereichen in unterschiedlichen Tiefen des Siliziumsubstrats, **dadurch gekennzeichnet, dass** die Verfahrensschritte nach Anspruch 1 mehrmals hintereinander unter Verwendung unterschiedlicher Maskierungen auf das Siliziumsubstrat angewendet werden.

5. Verfahren nach Anspruch 1, **dadurch gekennzeichnet, dass** nach der Herstellung des Hohlraums der Ätzprozess unter den gleichen Bedingungen wie bei der Herstellung des porösen Bereichs fortgesetzt wird, wobei insbesondere vorgesehen ist, dass durch die Fortsetzung des Ätzprozesses ein dem zuvor erzeugten porösen Bereich gegenüberliegender weiterer poröser Bereich erzeugt wird, wobei vorgesehen ist, dass der zuvor erzeugte poröse Bereich und der weitere Bereich den Hohlraum begrenzen.

6. Struktur in einem Siliziumsubstrat mit wenigstens
- einem ersten im sichtbaren Spektralspektrum optisch transparenten oxidierten porösen Bereich und
- einem unter dem ersten oxidierten porösen Bereich liegenden Hohlraum, und
- einem zweiten im sichtbaren Spektralspektrum optisch transparenten oxidierten porösen Bereich,
wobei vorgesehen ist, dass
- wenigstens der Hohlraum und der erste poröse Bereich mittels eines gemeinsamen insbesondere elektrochemischen Ätzprozesses erzeugt wurden und
- der erste und zweite poröse Bereich in unterschiedlichen Tiefen des Siliziumsubstrats erzeugt wurden,
**dadurch gekennzeichnet, dass**
der Hohlraum als Kanal ausgebildet ist.

7. Struktur nach Anspruch 6, **dadurch gekennzeichnet, dass** der Hohlraum von den gegenüberliegenden im sichtbaren Spektralbereich optisch transparenten ersten und zweiten Bereichen begrenzt wird.

## Claims

1. Method for fabricating at least
- one porous region and
- one cavity situated below the porous region
in a silicon substrate,
the fabrication comprising the method steps
- producing the porous region in the silicon substrate by means of an electrochemical etching process and
- producing the cavity within the porous region by continuing the etching process, the conditions of the etching process being changed,
**characterized in that** a region that is optically transparent in the visible spectral range is produced in the silicon substrate by oxidation of the porous region.

2. Method according to Claim 1, **characterized in that**, for the purpose of producing the cavity, the concentration of the etching solution in the etching process is reduced and/or the current intensity of the electrochemical etching process is increased.

3. Method according to Claim 1, **characterized in that** the cavity is configured as a channel.

4. Method for producing a plurality of regions that are optically transparent in the visible spectral range in different depths of the silicon substrate,
**characterized in that** the method steps according to Claim 1 are applied to the silicon substrate repeatedly in succession using different maskings.

5. Method according to Claim 1, **characterized in that** after the fabrication of the cavity, the etching process is continued under the same conditions as in the fabrication of the porous region, it being provided in particular that a further porous region opposite the previously produced porous region is produced by the continuation of the etching process, it being provided that the previously produced porous region and the further region delimit the cavity.

6. Structure in a silicon substrate having at least
- one first oxidized porous region that is optically transparent in the visible spectral spectrum and
- one cavity lying below the first oxidized porous region, and
- one second oxidized porous region that is optically transparent in the visible spectral spectrum,
it being provided that
- at least the cavity and the first porous region were produced by means of a common in particular electrochemical etching process and
- the first and second porous regions were produced in different depths of the silicon substrate,
**characterized in that**
the cavity is formed as a channel.

7. Structure according to Claim 6, **characterized in that** the cavity is delimited by the opposite first and second regions that are optically transparent in the visible spectral range.

## Revendications

1. Procédé de fabrication d'au moins :
- une zone poreuse et
- une cavité sous la zone poreuse
dans un substrat de silicium,
comprenant les opérations de base consistant à
- produire la zone poreuse dans le substrat de silicium à l'aide d'un processus l'érosion électrochimique, et
- produire la cavité dans la zone poreuse en prolongeant le processus d'érosion, les conditions du processus d'érosion étant modifiées,
**caractérisé en ce que**
on produit une zone optiquement transparente dans le domaine spectral visible par oxydation de la zone poreuse dans le substrat de silicium, .

2. Procédé selon la revendication 1,
**caractérisé en ce que**
pour créer la cavité, on réduit la concentration de la solution corrosive lors du processus d'érosion et/ou on augmente l'intensité du courant du processus d'érosion électrochimique.

3. Procédé selon la revendication 1,
**caractérisé en ce que**
la cavité est en forme de canal.

4. Procédé pour produire plusieurs zones optiquement transparentes dans le domaine spectral visible à différentes profondeurs du substrat de silicium,
**caractérisé en ce que**
les étapes du procédé selon la revendication 1 sont appliquées plusieurs fois les unes après les autres sur le substrat de silicium en utilisant différents masquages.

5. Procédé selon la revendication 1,
**caractérisé en ce qu'**
après la fabrication de la cavité, le processus d'érosion se poursuit dans les mêmes conditions que lors de la fabrication de la zone poreuse, sachant qu'on prévoit notamment que la prolongation du processus d'érosion entraîne la production d'une autre zone poreuse opposée à la première produite, tout en prévoyant qu'elles délimitent toutes deux la cavité.

6. Structure dans un substrat de silicium doté d'au moins
- une première zone poreuse optiquement transparente oxydée dans le domaine spectral visible,
- une cavité se trouvant sous la première zone poreuse oxydée et
- une deuxième zone poreuse optiquement transparente oxydée dans le domaine spectral visible,
et on crée
- au moins la cavité et la première zone poreuse à l'aide d'un processus d'érosion commun, notamment électrochimique, et
- la première et la deuxième zone poreuse à différentes profondeurs du substrat de silicium,
**caractérisée en ce que**
la cavité est en forme de canal.

7. Structure selon la revendication 6,
**caractérisée en ce que**
la cavité est délimitée par la première et la deuxième zone optiquement transparente opposées dans le domaine spectral visible.
